# EUROPEAN PATENT APPLICATION

(11) **EP 3 438 722 A1**
(43) Date of publication of application: **06.02.2019**
(21) Application number: 17184848.4
(22) Date of filing: 04.08.2017
(51) Int. Cl.: G02B 19/00, F21V 5/04, F21V 7/00, H01L 33/54

(54) **OPTICAL EMISSION DEVICE**

(71) Applicant: Optosys SA, 1720 Corminboeuf (CH)
(72) Inventor: Rhême, Charles, 1725 Posieux (CH)
(74) Representative: AMMANN PATENTANWÄLTE AG BERN

(57) **Abstract**

The invention relates to an optical emission device comprising
- an optical element (11, 111, 211, 311) formed from a material with a refractive index larger than 1.0 in a shape comprising at least a lateral surface portion (16, 116, 216, 316) a top surface portion (18, 118, 218, 318), and a bottom surface portion (14, 114, 214, 314) that are rotationally-symmetric to an optical axis (12); and
- a mount (2) for a light emitter (3) on the optical axis (12) below the bottom surface portion of the optical element (11, 111, 211, 311) such that at least a part of the light emitted from the light emitter (3) can enter the optical element (11, 111, 211, 311) through the bottom surface portion and be reflected on the lateral surface portion before leaving the optical element (11, 111, 211, 311) through the top surface portion.

To provide the optical emission device with the ability to produce an outgoing light beam having a sufficiently small beam size, in particular with regard to the design limitations caused by comparatively small device dimensions, the invention suggests that the lateral surface portion (16, 116, 216, 316) has an inclined course (47, 116, 216, 347) relative to the optical axis (12), said inclined course of the lateral surface portion being chosen such that the light (73, 74, 171, 271, 272, 373, 374) reflected at the lateral surface portion is not directed in parallel to the optical axis (12), and that the top surface portion (18, 118, 218, 318) has an inclined course (23, 28, 123, 223, 323) relative to an imaginary plane perpendicular to the optical axis (12), said inclined course of the top surface portion being chosen such that the light (73, 74, 171, 271, 272, 373, 374) leaving the optical element (11, 111, 211, 311) through the top surface portion is substantially directed in parallel to the optical axis (12).

## Description

The present invention relates to an optical emission device comprising
- an optical element formed from a material with a refractive index larger than 1.0 in a shape comprising at least a lateral surface portion, a top surface portion, and a bottom surface portion that are rotationally-symmetric to an optical axis; and
- a mount for a light emitter on the optical axis below the bottom surface portion of the optical element such that at least a part of the light emitted from the light emitter can enter the optical element through the bottom surface portion and be reflected on the lateral surface portion before leaving the optical element through the top surface portion.

Optical devices employing a light emitter as a source to generate an outgoing optical beam are used over a wide range of applications. Optical sensors for the detection of the presence or position of an object are an important example. They require a targeting of the outgoing optical beam on the respective object. In order to ensure such a targeting and thus detection of the object in a reliable manner, it is desirable that the size of the emitted light beam is as small as possible such that the size of the light spot on the target can be minimized. This property is all the more important for a detection of rather small objects.

Further significant for a production of these optical devices is an ongoing trend of continuing miniaturization. For this reason, semiconductor devices, such as laser diodes or light emitting diodes (LEDs), are a preferred choice for a suitable light emitter. Yet laser beams are often avoided, in particular due to safety issues related to an undesired high intensity of the emitted coherent light. LEDs do not have this disadvantage. But the undirected nature of light emission from such a spontaneous emission source poses the problem of a rather large optical beam size.

Usually, a refractive optical element, i.e. an optical element having a refractive index larger than 1.0, is applied to focus the outgoing light beam to a smaller spot size at a predetermined distance from the optical emission device. In many cases, this refractive optical element is provided by a single lens. The image dimensions of the emitted light at the predetermined distance from the optical emission device are then determined by the laws of geometrical optics. It follows that, in order to obtain an image with small dimensions at the predetermined distance, it is required to choose a light emitter of small dimensions and a lens having a focal length as large as possible. But an appropriate choice of the lens dimensions, in particular of a rather large lens diameter and focal length, is intrinsically limited by the dimensions of the optical emission device. The ongoing miniaturization of those devices therefore only permits an application of lenses having a comparatively small lens diameter and focal length. This results, however, in a rather large optical beam size at the position of the targeted object.

Another quality improvement of the outgoing light beam may be achieved by applying an additional refractive optical element, such as a second lens, or a different design of a refractive optical element in order to lead or deflect the emitted light in a favored direction. Such an optical emission device has been proposed in U.S. patent application No. 13/555,471. The device is an optical proximity switch comprising a receiving Fresnel lens, a transmitting lens, and a Lambertian emitter. The transmitting lens is formed in a shape allowing an increased collection of the light emitted by a LED. But it produces a diverging beam with an opening angle of 7° for a lens diameter of 21.6 mm. Therefore, this optical device can be useful to obtain an increased amount of light on a given surface. But it does not allow to focus the outgoing light beam to a sufficiently small spot size that would be desirable for a device with small dimensions.

It is an object of the present invention to remedy at least one of the above mentioned disadvantages and to provide the initially addressed optical emission device with the ability to produce an outgoing light beam having a sufficiently small beam size, in particular with due regard to the design limitations caused by comparatively small device dimensions. It is a further object to provide the optical emission device with the capability of an increased output power, in particular without employing a more powerful light source, and/or of an improved output efficiency. It is another object to allow a compact composition of such an optical emission device, preferably without compromising the functionality and/or production costs of the device. It is yet another object to provide the optical emission device in such a way that different angular ranges of light emission from the light emitter can be accounted for by different optical means being specifically appropriate for each of those angular ranges.

At least one of these objects is achieved by the optical emission device according to claim 1. The dependent claims define preferred embodiments.

Accordingly, the invention suggests that the lateral surface portion of the optical element has an inclined course relative to the optical axis, wherein the inclined course of the lateral surface portion is chosen such that the light reflected at the lateral surface portion is not directed in parallel to the optical axis. In addition, the top surface portion of the optical element has an inclined course relative to an imaginary plane perpendicular to the optical axis, wherein the inclined course of the top surface portion is chosen such that the light leaving the optical element through the top surface portion is substantially directed in parallel to the optical axis. In this way, the light emitted from the light emitter can be effectively narrowed such that a collimated outgoing light beam with a reduced beam size can be produced. Such an optical element can be fabricated with a diameter suitable for small device dimensions of the optical emission device.

In order to focus the incoming radiation to a narrower beam, at least one of the lateral surface portion, top surface portion, and bottom surface portion of the optical element is preferably curved. According to a preferred configuration, the curvature is provided at least at the lateral surface portion, in particular at its inclined course relative to the optical axis. In this way, a collection and narrowing of the incoming light beam can be performed at the lateral surface portion in a length direction of the optical element along the optical axis rather than in a width direction perpendicular to the optical axis. As a result, the diameter of the optical element corresponding to the maximum width perpendicular to the optical axis can be chosen more freely, wherein the focusing property of the optical element may not be compromised by a preferred selection of a rather small diameter of the optical element.

According to a preferred configuration, the aspect ratio of the optical element is not larger than 1.5, more preferred not larger than 1.3 and most preferred not larger than 1.2, the aspect ratio being defined as the ratio of the maximum width of the optical element perpendicular to the optical axis to the length of the optical element in the direction of the optical axis. This can be exploited for a design of the optical emission device having rather small device dimensions.

Preferably, the curvature of the optical element is convex at the lateral surface portion such that the lateral surface portion curves away from the optical axis. In relation to the light entering the optical element through the bottom surface portion to be reflected on the lateral surface portion, this preferred convex curvature of the optical element at the lateral surface portion corresponds to a concave curvature of the lateral surface portion seen from the inner volume of the optical element with respect to the surroundings of the optical element. As a result of this curvature, the incoming light beam can be effectively narrowed after reflection at the lateral surface portion inside the inner volume of the optical element.

Subsequently, a lateral section of the optical element is defined as an imaginary plane in which the optical axis is arranged. A cross section of the optical element is subsequently defined as an imaginary plane perpendicular to the optical axis.

Preferably, the curvature of the respective surface portion of the optical element is defined by curves of a conic section. Preferably, each curve of a conic section defines the curvature of the respective surface portion in a respective lateral section of the optical element. Preferably, each cross section of the respective surface portion is circular and centered at the optical axis. In general, the curves of the conic section may comprise a section of at least one of a parabola, a hyperbola, and an ellipse.

Thus, said curves of a conic section preferably form an envelope of the respective surface portion, in particular by a circular arrangement of said curves of a conic section around the optical axis. Preferably, the arrangement is rotational symmetric with respect to the optical axis. According to a preferred configuration, each of said curves of a conic section has a symmetry axis that is tilted at a tilt angle relative to the optical axis. In this way, the incoming light can be collimated in a preferred direction at the respective surface portion, in particular in such a way that substantially all parts of the incoming light are directed in the same direction after interaction with the respective surface portion. As a result, a substantially parallel alignment of the constituent parts of the outgoing light beam can be provided.

Preferably, a focal point of the conic section for each of said curves is spaced apart from the optical axis. According to a preferred configuration, the focal point for each of the curves is located on an imaginary plane perpendicular to the optical axis. The focal point for each of the curves is preferably located on an imaginary circle centered at the optical axis. Such a geometry of the respective surface portion can advantageously combine the effect of a light collection over a comparatively large emission angle of the light emitter with the effect of narrowing the collected light to a collimated light beam.

According to a preferred configuration, the conic section is a section of a parabola. The section of the parabola is subsequently referred to as parabolic section. Thus, the focal point of the conic section for each of said curves is preferably located on an axis of symmetry associated with the respective parabola representing the parabolic section for each of said curves. This axis of symmetry is subsequently referred to as axis of symmetry of the parabolic section. For instance, the parabola may be defined in Cartesian coordinates (x, y) by the values y of the analytic function y = a · x² for a set of all real numbers x and a constant a ≠ 0. The parabolic section may then be defined by the values y for a certain range of real numbers x. The focal point of the parabolic section may then be located on the axis of symmetry of the parabolic section represented by the axis of symmetry of the parabola, in particular at a distance f = 1/(4 · a) from the origin of the parabola at the Cartesian coordinates (x = 0, y = 0). Preferably, each curve of the parabolic section thus defines the curvature of the respective surface portion in a respective lateral section of the optical element.

According to a preferred configuration, the axis of symmetry of the parabolic section for each of said curves of the parabolic section is tilted at a tilt angle with respect to the optical axis. Preferably, the tilt angle is in a range between 1 ° and 30°, more preferred in a range between 2° and 20°, and most preferred in a range between 5° and 15°. Preferably, the tilt angle is substantially the same for each of said curves of the parabolic section. Preferably, the axis of symmetry of the parabolic section intersects the optical axis at a point of intersection. Preferably, the point of intersection is substantially the same for each of said curves of the parabolic section.

In this preferred configuration, each of said curves of the parabolic section thus corresponds to each other curve of said curves of the parabolic section after a rotation of the axis of symmetry of the respective parabolic section around the optical axis. The respective surface portion can thus be described in this preferred configuration as a surface portion having the optical axis as an axis of symmetry that is tilted at a tilt angle with respect to the axis of symmetry of the parabolic sections which are encircling the optical axis over an angular range of 360°. A circumference of the respective surface portion is thus preferably provided by the curves of the parabolic section encircling the optical axis in a rotational symmetric manner. Such a shape of the respective surface portion can allow an easy implementation fulfilling the above mentioned advantages of a far reaching light collection from the light emitter combined with an effective narrowing of the light to a collimated light beam.

According to another preferred configuration, the tilt angle can be varied for different curves of said curves of the parabolic section which form an envelope of the respective surface portion. According to another preferred configuration, the constant a and/or the value range x of the analytic function y = a·x² describing the parabolic section can be varied for different curves of said curves of the parabolic section. According to another preferred configuration, the respective surface portion may be defined as a surface portion having the optical axis as an axis of symmetry around which a curve of another conic section, in particular a section of a hyperbola or an ellipse, is rotated around 360°. It is understood that many other configurations are conceivable for a skilled person.

Preferably, the bottom surface portion of the optical element comprises an inclined course relative to an imaginary plane perpendicular to the optical axis. The inclined course of the bottom surface portion is preferably chosen such that at least part of the light entering the optical element through the bottom surface portion is redirected in a different direction by dispersion at the bottom surface portion. Preferably, the inclined course of the bottom surface portion is configured such that the light is redirected in different directions at different entry positions of the inclined course of the bottom surface portion.

Preferably, the light is redirected in such a way that it propagates toward a lateral surface portion and/or an inner surface portion of the optical element. Preferably, the light is redirected in such a way that the propagation direction of the light is brought closer to the direction of the optical axis. Preferably, the inclined course of the bottom surface portion is configured such that at least one virtual focal point of the light entering the bottom surface portion is provided. Preferably, at least part of the light redirected at the bottom surface portion in different directions can thus be linearly extrapolated at the bottom surface portion to coincide at the respective virtual focal point. Preferably, at least one virtual focal point of the bottom surface portion in a respective lateral section of the optical element coincides with a focal point of said curves of a conic section in the same lateral section of the optical element.

The inclined course of the bottom surface portion is preferably provided by a substantially linear gradient of the bottom surface portion towards the optical axis relative to said imaginary plane perpendicular to the optical axis. In this way, the light entering the optical element through the bottom surface portion can be oriented in an optical path toward the lateral surface portion that is optimized for the above described light collection and narrowing to a collimated light beam at the lateral surface portion. Preferably, the linear gradient of the bottom surface portion towards the optical axis has a gradient angle to the optical axis in a range between 10° and 50°, more preferred in a range between 20° and 45°, and most preferred in a range between 25° and 40°.

Preferably, a respective virtual focal point is provided for each lateral section of the optical element. Preferably, the light beams redirected in a different direction at the bottom surface portion have the same respective virtual focal point for each lateral section of the optical element. Preferably, a virtual focal point of the bottom surface portion coincides with a respective focal point of said curves of a conic section for each lateral section of the optical element. Preferably, the virtual focal points of the bottom surface portion are located on an imaginary plane perpendicular to the optical axis. In particular, the virtual focal points of the bottom surface portion are preferably located on an imaginary circle centered at the optical axis. Preferably, the virtual focal points of the bottom surface portion substantially match the focal points of each of said curves of a conic section.

To provide such a virtual focal point for each lateral section of the optical element, the inclined course of the bottom surface portion is preferably provided with a rotationally symmetric shape around the optical axis. In this way, substantially all the light entering the optical element through the bottom surface portion can be oriented in an optimized optical path toward the lateral surface portion. Moreover, a virtual focal point for each lateral section of the bottom surface portion can thus be provided, wherein the virtual focal points of all lateral sections of the bottom surface portion around the optical axis are located on an imaginary circle centered at the optical axis. Preferably, the rotationally symmetric shape of the bottom surface portion is provided by a conic surface. The conic surface of the bottom surface portion preferably tapers in the upper direction of the optical element. The tapering is preferably provided by the linear gradient of the bottom surface portion towards the optical axis. Thus, the conic surface preferably expands toward the bottom surface portion at the gradient angle of the bottom surface portion relative to the optical axis.

According to a preferred configuration, the bottom surface portion of the optical element comprises an inner surface portion provided inside a cavity at a bottom side of the optical element. This allows to position the light emitter relatively close to the bottom surface portion inside the cavity such that optical losses can be minimized. The mount for the light emitter is preferably configured such that the light emitter is placed inside the cavity at the bottom side of the optical element. This configuration is particularly advantageous to collect light being laterally emitted from the light emitter, in particular light emitted at an emission angle to the optical axis that is larger than 20°.

According to another preferred configuration, the light emitter is arranged below the bottom surface portion outside the optical element. Accordingly, the mount for the light emitter is preferably configured such that the light emitter is placed below the bottom side of the optical element, in particular below an inner cavity at the bottom side of the optical element. This configuration is particularly advantageous to not only collect light being laterally emitted from the light emitter but also the light being emitted in a straightforward direction, in particular when also light emitted at an emission angle to the optical axis below 20° shall be collected in the optical element.

According to a first preferred configuration, the light emitter is provided in such a way that the emitted light interacts with the optical element substantially without changing the direction of the light emitted from the light emitter. In particular, no additional refractive element, such as a lens, is preferably provided in between the light emitter and the optical element in this configuration. According to a second preferred configuration, an additional refractive element altering the direction of the light emitted from the light emitter is provided in between the light emitter and the optical element. In particular, the light emitter may be surrounded by a lens in this configuration, the lens being formed from a material having a refractive index larger than 1.0. According to a preferred implementation, such a lens has a substantially hemispheric shape.

Preferably, the inclined course of the top surface portion of the optical element is provided by a substantially linear gradient of the top surface portion towards the optical axis relative to the imaginary plane perpendicular to the optical axis. In this way, the light reflected at the lateral surface portion can be redirected by dispersion at the top surface portion such that the previously narrowed and collimated light beam is further narrowed and directed in parallel to the optical axis when leaving the optical element. Preferably, the top surface portion of the optical element rises along the linear gradient toward the optical axis at a gradient angle. The inclined course of the top surface portion is preferably provided with a rotationally symmetric shape around the optical axis such that the gradient angle is substantially constant for all sections of the top surface portion around the optical axis.

According to a first preferred configuration, the optical element is substantially solid at the top surface portion. This configuration is particularly advantageous to also collect the light being emitted from the light emitter in a straightforward direction along the optical axis, in particular when also light emitted at an emission angle to the optical axis below 20° shall be collected. In this configuration, the linear gradient of the top surface portion towards the optical axis preferably has a gradient angle to the optical axis in a range between 40° and 90°, more preferred in a range between 60° and 90°, and most preferred in a range between 70° and 80°. In this configuration, a center section of the top surface portion surrounded by an outer section of the top surface portion having the inclined course is preferably substantially flat with respect to the imaginary plane perpendicular to the optical axis.

According to a second preferred configuration, the optical element comprises an inner cavity at a top side. The inner cavity at the top side of the optical element is preferably surrounded by the top surface portion having the inclined course relative to the imaginary plane perpendicular to the optical axis. This configuration is particularly advantageous to collect light being laterally emitted from the light emitter, in particular light emitted at an emission angle to the optical axis that is larger than 20°. In this configuration, the linear gradient of the top surface portion towards the optical axis preferably has a gradient angle to the optical axis in a range between 30° and 90°, more preferred in a range between 50°and 70°, and most preferred in a range between 55°and 65°.

Preferably, the cavity extends through a total length of the optical element from the bottom surface portion to the top surface portion of the optical element such that at least part of the light emitted from the light emitter can travel through the cavity. Preferably, the cavity is limited laterally by an inner surface portion of the optical element. Preferably, the inner surface portion comprises an inclined course with respect to the optical axis. The inclined course of the inner surface portion at the top side of the optical element preferably extends toward the top surface portion of the optical element away from the optical axis. Thus, the inclined course of the inner surface portion at the top side of the optical element preferably tapers in the bottom direction of the optical element. The cavity preferably has a cross section expanding toward the top surface portion such that an inner diameter of the cavity increases toward the top side of the optical element. The inclined course of the inner surface portion is preferably provided with a rotationally symmetric shape around the optical axis.

The inclined course of the inner surface portion at the top side of the optical element is preferably provided by a substantially linear gradient of the inner surface portion towards the top surface portion pointing away from the optical axis at an opening angle of the cavity. The cavity is thus preferably delimited by a conic surface expanding at an opening angle relative to the optical axis toward the top surface portion of the optical element. This allows to extract the light emitted from the light emitter at an angular range within this opening angle relative to the optical axis through the cavity. In this way, different angular ranges of light emission from the light emitter can be advantageously accounted for by different optical means. According to a preferred configuration, the opening angle of the inclined course of the inner surface portion relative to the optical axis is in a range between 10° and 40°, more preferred in a range between 15° and 30°, and most preferred in a range between 20° and 25°. Thus, the light emitted from the light emitter above this angular value relative to the optical axis can be accounted for by the optical properties of the optical element. Conversely, the light emitted below this angular value relative to the optical axis can pass through the cavity of the optical element allowing a different optical manipulation of this light portion.

Preferably, the cavity extending through the total length of the optical element comprises a top portion at a top side of the optical element and a bottom portion at a bottom side of the optical element. The bottom portion of the cavity is preferably laterally delimited by an inner surface portion of the optical element by which the inclined course of the bottom surface portion is provided. The top portion of the cavity is preferably laterally delimited by an inner surface portion of the optical element expanding toward the top surface portion at an inclined course. Thus, both the top portion of the cavity and the bottom portion of the cavity preferably taper toward the inside of the optical element. Preferably, the top portion of the cavity and the bottom portion of the cavity are joined at a circular connecting edge provided at the inner surface portion of the optical element. Preferably, the bottom portion of the cavity is laterally delimited by a conic surface expanding toward the bottom side of the optical element. Preferably, the top portion of the cavity is laterally delimited by a conic surface expanding toward the top side of the optical element. The connecting edge thus preferably constitutes a connection in between the two conic surfaces. According to a preferred configuration, the height of the bottom portion of the cavity in parallel to the optical axis is not larger than half, more preferred one third, of the height of the top portion of the cavity in parallel to the optical axis.

Preferably, a converging lens is provided at a top side of the optical element. The lens is preferably configured such that the light traveling through the cavity of the optical element is directed in parallel to the optical axis. Preferably, the lens comprises a convex surface facing a top side of the optical element. In this way, the lens can be applied to provide a collimation of the light emitted from the light emitter at an angular range smaller than the angular range of the emitted light passing through the optical element. According to a preferred configuration, the lens is arranged in between an inner edge of the inclined course of the top surface portion such that it extends into the cavity. In this way, the device dimensions can be further reduced with regard to a compact device size.

Preferably, a front cover is provided on top of the top surface portion, the front cover being transparent to at least part of the light leaving the optical element through the top surface portion. On the one hand, the front cover can serve as a device protection. For instance, it can be integrated as a part of a housing of the device. On the other hand, the front cover can also provide an additional functionality, e.g. an optical filter. Preferably, the lens is provided on the front cover, in particular in such a way that the lens is substantially covering said cavity at the top side of the optical element. This can allow a facilitated fixation of the lens at the desired position and may also contribute to a reduced complexity of the device with a smaller number of constituent parts.

According to a first preferred configuration, the optical element comprises a substantially empty cavity in order to allow a selective light extraction of different angular ranges of the light emitted from the light emitter in the above described manner. According to a second preferred configuration, at least an inner optical element is provided inside the cavity. Preferably, the inner optical element is applied in place of the above described lens. This can allow further improved optical properties of the emission device, in particular with respect to a narrowing and collimation of the outgoing light beam. Alternatively, the inner optical element is preferably applied in addition to a lens as described above, wherein the lens is then preferably provided at a top side of the inner optical element, in particular such that the lens is arranged in between an inner edge of an inclined course of a top surface portion of the inner optical element such that it extends into a cavity of the inner optical element. This can be exploited for a further refinement of the selective light extraction from the light emitter.

Preferably, the inner optical element is also formed from a material with a refractive index larger than 1.0 in a shape comprising at least a lateral surface portion, a top surface portion, and a bottom surface portion that are rotationally-symmetric to the optical axis. The general geometrical shape of the inner optical element is preferably similar or analogous to the optical element described above, wherein preferred differences are described below.

Preferably, the inner optical element is arranged inside the cavity of the optical element in such a way that the optical axis of the optical element coincides with the optical axis of the inner optical element. Preferably, the lateral surface portion of the inner optical element runs along the inner surface portion of the optical element. Preferably, the lateral surface portion of the inner optical element has an inclined course with respect to the optical axis defined by curves of a parabolic section having an axis of symmetry being tilted at a tilt angle with respect to the optical axis. The tilt angle is preferably smaller as compared to the tilt angle of the axis of symmetry of the curves of the parabolic section defining the lateral surface portion of the optical element in which the inner optical element is arranged.

Preferably, the bottom surface portion of the inner optical element is arranged inside the bottom portion of the cavity of the optical element. Preferably, the bottom surface portion of the inner optical element comprises a substantially flat course parallel to an imaginary plane perpendicular to the optical axis. In this way, the light emitted from the light emitter at an angular range smaller than the opening angle of the cavity of the optical element can be advantageously coupled into the inner optical element. According to a preferred configuration, the cavity of the inner optical element is closed at the bottom surface portion.

Preferably, the cavity of the inner optical element comprises an inner surface portion having an inclined course with respect to the optical axis. Preferably, the light entering the bottom surface portion of the inner optical element is directed toward the inclined inner surface portion such that it is reflected from the inner surface portion toward the lateral surface portion. Preferably, the geometry of the inner optical element is configured such that the light is reflected at least two times inside the inner optical element, in particular a first time at the inner surface portion and a second time at the lateral surface portion, before it leaves the inner optical element through the top surface portion. Preferably, the inclined course of the inner surface portion defines at least one virtual focal point of the light reflected at the inner surface portion. Preferably, the virtual focal point of the inner surface portion coincides with at least one focal point of the curves of a conic section defining the inclination of the lateral surface portion.

Preferably, the inclined course of the inner surface portion of the inner optical element is configured such that the optical path of at least part of the light reflected at the inner surface portion in different directions can be extrapolated to coincide at the virtual focal point. Preferably, a respective virtual focal point is provided for each lateral section of the inner surface portion in the plane of the optical axis. Preferably, the virtual focal points of the inner surface portion are located on an imaginary plane perpendicular to the optical axis. In particular, the virtual focal points of the inner surface portion are preferably located on an imaginary circle centered at the optical axis. Preferably, the virtual focal points of the inner surface portion substantially match the focal points of each of said curves of a conic section which define a curvature of the lateral surface portion.

Preferably, the inclined course of the inner surface portion has the form of a conical surface having a linear gradient towards the top surface portion. Preferably, the inclined course is at least provided in a bottom portion of the cavity of the inner optical element. According to a preferred configuration, the cavity of the inner optical element also comprises an inner surface portion having a substantially parallel course with respect to the optical axis. Preferably, the substantially parallel course is provided in a top portion of the cavity of the inner optical element.

Preferably, the refractive index of the material of the optical element and/or the inner optical element is at least 1.3, more preferred at least 1.5, and most preferred at least 1.6 in order to provide sufficiently high dispersion and/or reflection properties. In particular, substantially a total reflection of the light at the lateral surface portion and/or at the inner surface portion of the optical element is preferred. Preferably, the refractive index of the material of the optical element and/or the inner optical element is at most 3.0, more preferred at most 2.5, and most preferred at most 2.0 in order to render undesired side effects such as chromatic aberration sufficiently small for many desired applications. A preferred material of the optical element comprises a poly-methyl methacrylate (PMMA) and/or a polycarbonate (PC). More preferred, the optical element substantially consists of one of these materials. The light emitter is preferably provided by a spontaneously emitting light source, in particular a LED.

The invention is explained in more detail hereinafter by means of preferred embodiments with reference to the drawings which illustrate further properties and advantages of the invention. The following description of the preferred embodiments is not intended as a limitation of the scope of the invention that has been described more generally above and is solely defined by the claims. The figures, the description, and the claims comprise numerous features in combination that one skilled in the art may also contemplate separately and use in further appropriate combinations. In the drawings:
- Fig. 1: is a schematic representation in an exploded view of an optical emission device according to a first embodiment seen from a bottom perspective;
- Fig. 2: is a schematic representation in an exploded view of the optical emission device shown in Fig. 1 seen from a top perspective;
- Fig. 3: is a schematic representation of the optical emission device shown in Figs. 1 and 2 in a lateral sectional view, wherein the optical emission device further includes a front cover;
- Fig. 4: is a schematic representation in an exploded view of an optical emission device according to a second embodiment seen from a bottom perspective;
- Fig. 5: is a schematic representation of the optical emission device shown in Fig. 4 seen from a lateral perspective;
- Fig. 6: is a schematic representation of the optical emission device shown in Figs. 4 and 5 in a lateral sectional view;
- Fig. 7: is a schematic representation of an optical emission device according to a third embodiment in a lateral sectional view; and
- Fig. 8: is a schematic representation of an optical emission device according to a fourth embodiment in a lateral sectional view.

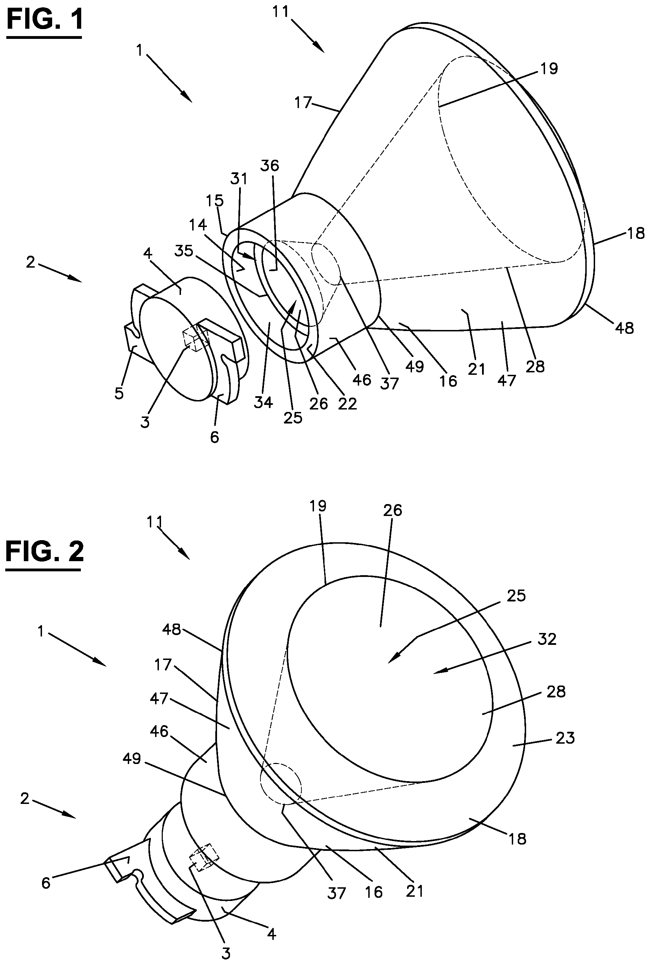

Figs. 1 - 3 depict an optical emission device 1 according to a first embodiment. Optical emission device 1 comprises a mount 2 for a light emitter 3, and an optical element 11. Mount 2 has a substantially circular cylindrical body 4 with light emitter 3 disposed on the central axis. Cylindrical body 4 has a conical cavity in which light emitter 3 is arranged. The conical cavity is delimited by an inner surface 78 of cylindrical body 4. Inner surface 78 is tapering toward the top of mount 2. The conical cavity is open at the top of cylindrical body 4 thus defining an aperture through which light can be emitted from light emitter 3 toward optical element 11. For instance, mount 2 is an LED having an active region represented by light emitter 3. Light emitter 3 is adapted to emit light over a large angular range of at least 90° relative to a central axis of cylindrical body 4. On a lateral surface of cylindrical body 4, two flat extensions 5, 6 are attached on opposed sides. Extensions 5, 6 facilitate the handling and can be used for an external fixation of mount 2.

Optical element 11 is formed from a material with a refractive index larger than 1.0 in a rotational-symmetric shape relative to an optical axis 12. Optical element 11 comprises a bottom surface 14 at a bottom side 15, a lateral surface 16 at a lateral side 17, and a top surface 18 at a top side 19. An external surface 21 of optical element 11 is constituted by lateral surface 16, an outer flat portion 22 of bottom surface 14, and an outer inclined portion 23 of top surface 18. Outer flat bottom surface portion 22 extends on an imaginary plane perpendicular to optical axis 12. Outer top surface portion 23 has an inclined course relative to an imaginary plane perpendicular to optical axis 12 in such a way that top surface portion 23 rises at a linear gradient toward optical axis 12.

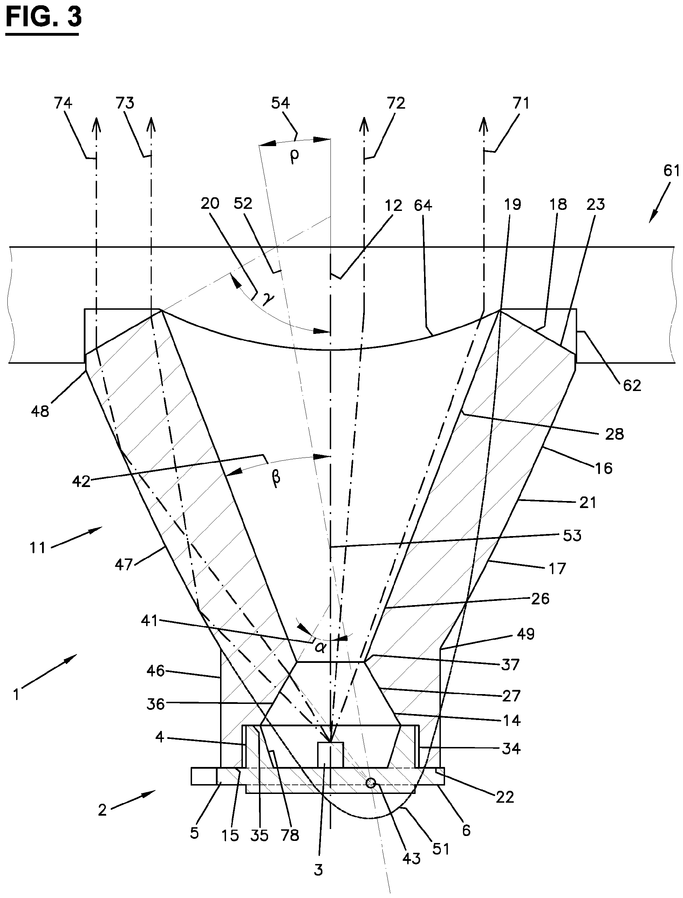

Fig. 3 shows a lateral section of optical emission device 1 in the plane of optical axis 12. In the embodiment shown in Fig. 3, a gradient angle 20 of top surface portion 23 relative to optical axis 12 is about γ = 60°. This corresponds to an inclination angle of top surface portion 23 relative to an imaginary plane perpendicular to optical axis 12 of about 90°- γ = 30°. The value of the inclination angle determines an angle at which the light passing through optical element 11 exits top surface portion 23. Thus, the inclination angle also determines a dispersion angle of the light outside optical element 11 after dispersion at this surface portion. The inclination angle is chosen such that the dispersion of the light at top surface portion 23 directs the light substantially in parallel to optical axis 12.

Optical element 11 further comprises a cavity 25 extending through a total length of optical element 11 along optical axis 12. Cavity 25 is open at bottom side 15 and at top side 19 of optical element 11. At bottom side 15, cavity 25 is surrounded by outer flat portion 22 of bottom surface 14. At top side 19, cavity 25 is surrounded by outer inclined portion 23 of top surface 18. Cavity 25 is delimited by an inner surface 26 of optical element 11. Inner surface 26 comprises an inner bottom surface portion 27 delimiting a bottom portion 31 of cavity 25 and an inner top surface portion 28 delimiting a top portion 32 of cavity 25. Inner bottom surface portion 27 comprises a circular cylindrical sidewall 34 adjoining outer flat portion 22 at bottom side 15 on a lower end and adjoining an inner flat portion 35 of inner bottom surface portion 27 on the opposed upper end. Optical axis 12 is directed in parallel to cylindrical sidewall 34. Cylindrical sidewall 34 and inner flat portion 35 delimit an insertion space at bottom side 15 of optical element 11 into which mount 2 of light emitter 3 can be fitted. After insertion of mount 2 into inner bottom surface portion 27, the central axis of cylindrical body 4 coincides with optical axis 12 such that light emitter 3 is disposed on optical axis 12.

Inner bottom surface portion 27 further comprises an inclined surface portion 36 having an inclined course relative to an imaginary plane perpendicular to optical axis 12. Inclined bottom surface portion 36 adjoins inner flat portion 35 at its lower end and rises at a linear gradient toward optical axis 12. Thus, inclined bottom surface portion 36 forms a conic surface expanding toward bottom side 15 of optical element 11. At its opposed upper end, inclined bottom surface portion 36 adjoins inner top surface portion 28 delimiting top portion 32 of cavity 25. Inner top surface portion 28 has an inclined course at a linear gradient relative to optical axis 12 such that it extends away from optical axis 12 on its course toward top side 19. Inner inclined top surface portion 28 thus forms a conic surface expanding toward top side 19 of optical element 11. Conic inner surfaces 28, 36 are joined at an inner connecting edge 37 in between inner bottom surface portion 27 and inner top surface portion 28.

The conic surface of inclined bottom surface portion 36 has a gradient angle 41 relative to optical axis 12. In the embodiment shown in Fig. 3, gradient angle 41 corresponds to a value of about α = 30°. This corresponds to an inclination angle of bottom surface portion 36 relative to an imaginary plane perpendicular to optical axis 12 of about 90° - α = 60°. The value of the inclination angle determines an angle at which the light emitted from light emitter 3 enters inclined bottom surface portion 36 and thus also the dispersion angle of the light inside optical element 11 after passage through this surface portion.

Due to the dispersion of light at inclined bottom surface portion 36, a virtual focal point 43 for the light entering bottom surface portion 36 is provided. Virtual focal point 43 is spaced apart from optical axis 12 at a position dependent from the inclination angle of bottom surface portion 36. Virtual focal point 43 is defined by a path of the light dispersed at bottom surface portion 36 that can be linearly extrapolated from inside the optical element 11 towards optical axis 12 for each light beam emitted from light emitter 3. The extrapolated paths of the light beams dispersed at bottom surface portion 36 then coincide in virtual focal point 43. Virtual focal point 43 is representative for a lateral section of bottom surface portion 36 in the same plane in which also optical axis 12 is located. Moreover, virtual focal point 43 is only representative for the part of this lateral section of bottom surface portion 36 that is arranged at the opposed side from optical axis 12. Thus, two virtual focal points exist on both sides of optical axis 12 for the lateral section of bottom surface portion 36, each virtual focal point 43 being representative for the part of lateral section of bottom surface portion 36 that is located on the opposed side of optical axis 12. Moreover, corresponding virtual focal points exist for each other lateral section of bottom surface portion 36 in the same plane than optical axis 12. Those lateral sections run around the conic surface of bottom surface portion 36 such that the virtual focal points 43 determined by inclined bottom surface portion 36 are arranged on a circle centered at optical axis 12 on an imaginary plane perpendicular to optical axis 12.

The conic surface of inner top surface portion 28 has a gradient angle 42 relative to optical axis 12. In the embodiment shown in Fig. 3, gradient angle 42 corresponds to a value of about β = 22°. Gradient angle 42 of inner top surface portion 28 determines an angular range with respect to optical axis 12 in which light emitted from light emitter 3 can pass through cavity 25 without entering in contact with optical element 11. This gradient angle is therefore also related to as opening angle 42.

Altogether, bottom surface 14 of optical element 11 is provided by outer flat portion 22 and inner bottom surface portion 27 comprising cylindrical sidewall 34, inner flat portion 35 and inclined surface portion 36. Top surface 18 of optical element 11 is provided by outer inclined top surface portion 23 and inner inclined top surface portion 28. Lateral surface 16 of optical element 11 comprises an outer lower cylindrical portion 46, an outer middle expanding portion 47, and an outer upper cylindrical portion 48.

Lower lateral surface portion 46 and middle lateral surface portion 47 are joined at an outer connecting edge 49. Outer connecting edge 49 is located at a similar height as inner connecting edge 37 with respect to optical axis 12, in particular only slightly higher than inner connecting edge 37. Thus, outer lower cylindrical surface portion 46 laterally encircles bottom portion 31 of cavity 25. Lower cylindrical surface portion 46 and upper cylindrical surface portion 48 extend in parallel to optical axis 12, wherein upper cylindrical surface portion 48 has a larger diameter of its cross section. At its upper end, upper cylindrical surface portion 48 adjoins outer top surface portion 23 at its outer end.

Middle lateral surface portion 47 extends from the upper end of lower cylindrical surface portion 46 to the lower end of upper cylindrical surface portion 48 along optical axis 12 with a continuously increasing diameter of its cross section, such that middle lateral surface portion 47 has an inclined course relative to optical axis 12. The inclined course corresponds to a convex curvature of this lateral surface portion 47. As seen from the perspective of the light beams travelling inside optical element 11, the curvature represents a concave reflection surface 47 for this light.

The curved shape of middle lateral surface portion 47 is defined by curves of a section of a parabola 51. In particular, each lateral section of lateral surface portion 47 that is located in the same plane than optical axis 12 is defined by such a curve of a parabolic section. An axis of symmetry 52 of parabola 51 is tilted with respect to optical axis 12 such that axis of symmetry 52 of parabola 51 crosses optical axis 12 at an intersection point 53. A tilt angle 54 in between axis of symmetry 52 of parabola 51 and optical axis 12 is chosen such that the focal point of parabola 51 substantially coincides with virtual focal point 43 of the light redirected at inclined bottom surface portion 36. In the embodiment shown in Fig. 3, tilt angle 42 corresponds to a value of about φ = 10°.

A circumference of middle lateral surface portion 47 is thus defined by the curves of a section of parabola 51 encircling optical axis 12 in a rotational symmetric manner. This results in a circular arrangement of the focal points of those curves of a parabolic section such that they are centered at optical axis 12 on an imaginary plane perpendicular to optical axis 12. The circle of focal points of those curves of a parabolic section substantially coincides with the circle of virtual focal points of the light redirected at inclined bottom surface portion 36 by dispersion.

Optical emission device 1 further comprises a top cover 61. Top cover 61 is only illustrated in Fig. 3. Top cover 61 is arranged above top side 19 of optical element 11. Top cover 61 is substantially plate-shaped and comprises a circular recess 62 adapted to be fitted on top surface portion 23 and on a top portion 48 of lateral surface 17. Top cover 61 consists of a substantially transparent material allowing a passage of the light passing through optical element 11 and passing through cavity 25.

A converging lens 64 is provided on top of cavity 25. Lens 64 has a convex surface facing cavity 25. In this way, light passing through cavity 25 within the angular range of opening angle 42 of inner top surface portion 28 is collimated by lens 64 in parallel to optical axis 12. A diameter of lens 64 substantially corresponds to the diameter of cavity 25 at top end 19 of optical element 11. Lens 64 forms an integral part of top cover 61. Lens 64 is surrounded by circular recess 62.

Subsequently, an exemplary mode of operation of optical emission device 1 based on a respective path of four light beams 71, 72, 73, 74, as illustrated in Fig. 3, is described. Light beams 71, 72 are emitted from light emitter 3 at an angular range relative to optical axis 12 below opening angle 42 of inner top surface portion 28. Therefore, light beams 71, 72 can pass through cavity 25 without being in contact with optical element 11. In consequence, light beams 71, 72 propagate on a path corresponding to the initial emission direction until they hit the convex surface of lens 64. Lens 64 causes a collimation of light beams 71, 72 in parallel to optical axis 12. Since only a comparatively small angular range of the emitted light relative to optical axis 12 has been selected to be focused by lens 64, which has been chosen to lie within opening angle 42 of inner top surface portion 28, lens 64 can provide a sufficient narrowing of the outgoing light beam.

Light beams 73, 74 are emitted from light emitter 3 at an angular range relative to optical axis 12 above opening angle 42 of inner top surface portion 28. Therefore, the initial propagation direction of light beams 73, 74 leads to inclined bottom surface portion 36 of optical element 11. Upon entering optical element 11 through inclined bottom surface portion 36, a dispersion of light beams 73, 74 takes place, wherein light beams 73, 74 are redirected with respect to common virtual focal point 43. The redirected path of light beams 73, 74 leads to inclined lateral surface portion 47. On inclined lateral surface portion 47, a total reflection of light beams 73, 74 takes place. Due to the curved shape of inclined lateral surface portion 47 defined by the curves of parabolic section 51 having a focal point at the position of virtual focal point 43 of inclined bottom surface portion 36, light beams 73, 74 collected over this comparatively large surface region 47 are collimated to a narrower entire beam after their total reflection. Reflected light beams 73, 74 are then directed toward outer inclined top surface portion 23. At top surface portion 23 another dispersion of light beams 73, 74 occurs resulting in a further narrowing of light beams 73, 74 in a parallel direction to optical axis 12. As a result, an effective light collection over a large emission range, which has been selectively chosen to lie outside opening angle 42 of inner top surface portion 28, can be achieved by optical element 11 and an effective collimation of this collected light to a narrow outgoing light beam.

During the course of the present invention it has been demonstrated that the above described optical emission device 1 can be successfully employed to significantly increase the output power of the outgoing light beam and at the same time to provide the outgoing light beam with a comparatively small beam size, as judged by a measurement of the full width of the beam at half of the maximum output power, i.e. the "Full Width Half Maximum" (FWHM). For instance, experiments have been carried out on a target set on a distance of 0.3 m from the device and both the output power and FWHM of a luminous spot on the target have been measured, using a LSP47F LED as a light source.

Measurements only using lens 64 as a means for collimation of the emitted light have shown the results of an output power value of 0.19 W and a spot size having a FWHM of 17 mm. Measurements only employing optical element 11 as a means for collimation of the emitted light have resulted in an output power value of 0.63 W and a spot size with a FWHM of 15 mm. This suggests that, even though the output power has increased by a factor of three, the FWHM has surprisingly not increased when the luminous spot has been projected on the target solely by optical element 11 instead of lens 64.

Measurements employing both optical element 11 and lens 64 as a means for collimation of the emitted light, as depicted in Fig. 3, have shown that an output power value of 0.84 W and a spot size with a FWHM of 16 mm can be achieved. This suggests that the output power can be further increased in this case, wherein the FWHM of the luminous spot can be still kept smaller as compared to the case when only lens 64 is applied. The inventive concept comprising the application of optical element 11 in the above described way is therefore useful to shape a thinner light beam and to increase the output power by a factor of four. In addition, the luminous collection efficiency of the LED has been determined in the latter experiment which has reached a percentage of 63% of the direct LED radiation.

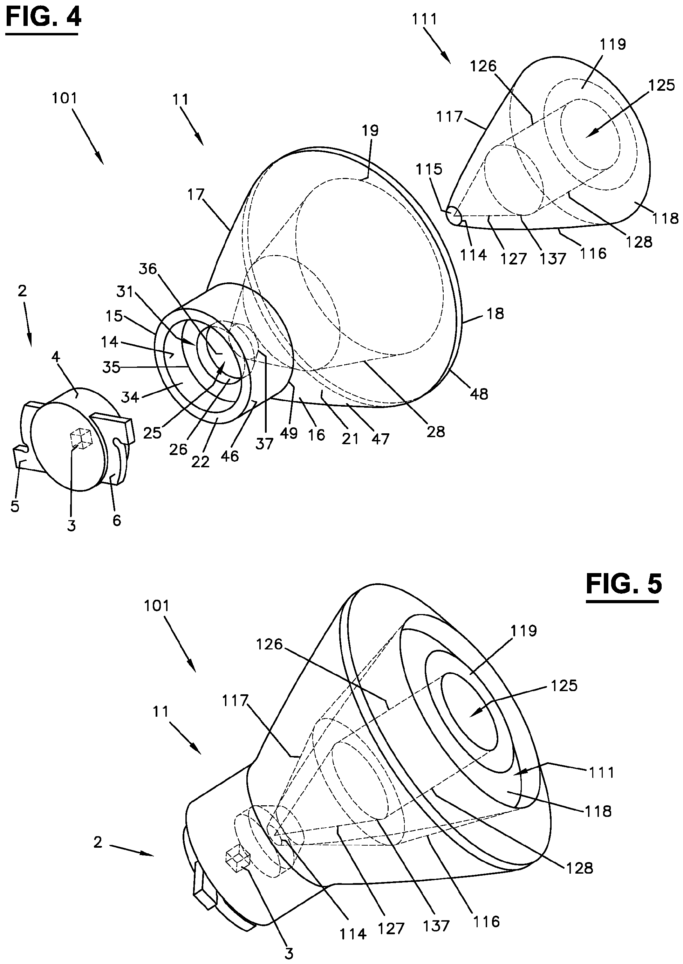

Figs. 4 - 6 depict an optical emission device 101 according to a second embodiment. Optical emission device 101 corresponds to optical emission device 1 according to the first embodiment in that it comprises mount 2 for light emitter 3 and optical element 11 in a similar or in the same configuration as shown in Figs. 1 - 3. Therefore, identical features pertaining to these constituent parts 2, 3, 11 are denoted in the following description by the same reference numbers. Different features of constituent parts 2, 3, 11 as compared to optical emission device 1 according to the first embodiment will be mentioned below. Moreover, optical emission device 101 is distinguished from optical emission device 1 according to the first embodiment in that it comprises an inner optical element 111.

Inner optical element 111 is formed from a material with a refractive index larger than 1.0 in a rotational-symmetric shape relative to optical axis 12. Inner optical element 111 comprises a bottom surface 114 at a bottom side 115, a lateral surface 116 at a lateral side 117, and a top surface 118 at a top side 119. Bottom surface 114, lateral surface 116, and top surface 118 constitute an external surface 121 of optical element 111. Optical element 111 further comprises a cavity 125. Cavity 125 is open at top side 119, where it is surrounded by top surface 118. Cavity 125 is closed at bottom side 115 by bottom surface 114. Bottom surface 114 is substantially flat such that it extends in parallel to an imaginary plane perpendicular to optical axis 12. Cavity 125 is delimited by an inner surface 126 of inner optical element 111. Inner surface 126 comprises an inner lower surface portion 127 delimiting a lower portion of cavity 125 and an inner upper surface portion 128 delimiting an upper portion of cavity 125. Inner upper surface portion 128 is formed by a circular cylindrical sidewall adjoining top surface 118 at an upper end. Optical axis 12 is directed in parallel to cylindrical sidewall 128.

Inner lower surface portion 127 has an inclined course at a linear gradient relative to optical axis 12 such that it continuously approaches optical axis 12 on its course toward bottom side 115. At bottom side 115, inner lower surface portion 127 reaches optical axis 12 such that the lower portion of cavity 125 is substantially only closed at bottom surface 114. Thus, cavity 125 substantially extends through a total length of optical element 111 along optical axis 12. Inner lower surface portion 127 forms a conic surface that is tapering toward bottom side 115 of optical element 115. Conic inner surface 127 and cylindrical inner surface 128 are joined at an inner connecting edge 137 in between inner lower surface portion 127 and inner upper surface portion 128.

Inclined inner surface portion 127 represents a reflection surface for the light entering optical element 111 through bottom surface 114. Due to the reflection of light at inclined inner surface portion 127, a virtual focal point 143 for the light entering bottom surface 114 is provided. Virtual focal point 143 is spaced apart from optical axis 12 at a position dependent from the inclination angle of inner surface portion 127. The linearly extrapolated paths of the light beams reflected at inner surface portion 127 coincide in virtual focal point 143. More particularly, two virtual focal points exist on both sides of optical axis 12 for each lateral section of inner surface portion 127, each virtual focal point 143 being representative for the part of lateral section of inner surface portion 127 that is located on the opposed side of optical axis 12. Corresponding virtual focal points exist for each other lateral section of inclined inner surface portion 127 that are located in the same plane than optical axis 12. Those virtual focal points 143 are arranged on a circle centered at optical axis 12 on an imaginary plane perpendicular to optical axis 12.

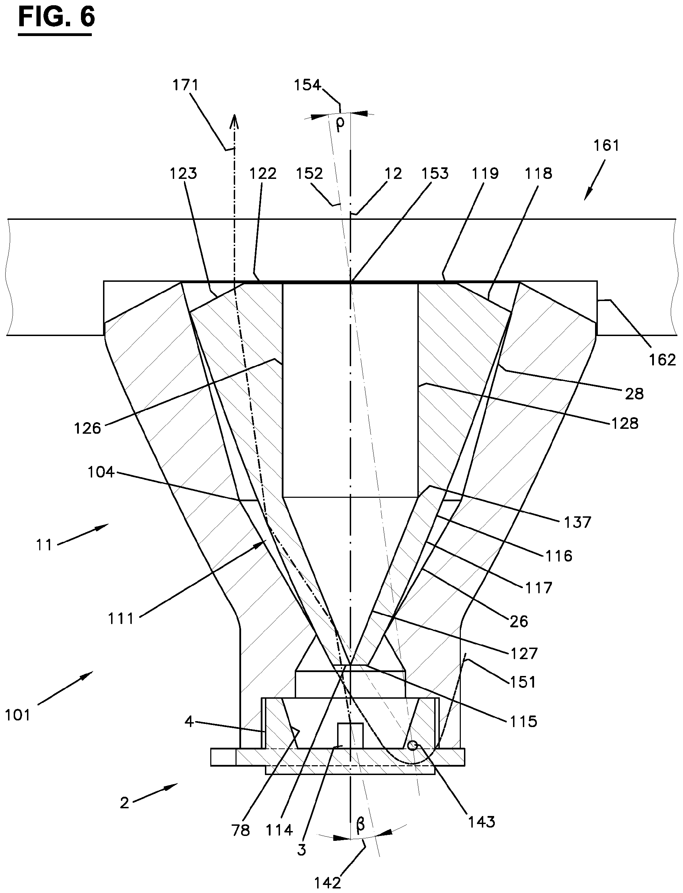

Top surface 118 of inner optical element 111 comprises an inclined surface portion 123 and a flat surface portion 122. Flat top surface portion 122 extends in parallel to an imaginary plane perpendicular to optical axis 12 and adjoins inner upper surface portion 128 at an inner end of top surface 118. Inclined top surface portion 123 adjoins lateral surface 116 at an outer end of top surface 118. Inclined top surface portion 123 has an inclined course relative to an imaginary plane perpendicular to optical axis 12 in such a way that top surface portion 123 rises at a linear gradient toward optical axis 12. Fig. 6 shows a lateral section of optical emission device 101 in the plane of optical axis 12. In the embodiment shown in Fig. 6, a gradient angle of top surface portion 123 is applied that has about the same value than gradient angle 20 of top surface portion 23 of optical element 11 relative to optical axis 12.

Lateral surface 116 extends over the total length of inner optical element 111 along optical axis 12 with a continuously increasing diameter of its cross section, such that lateral surface 116 has an inclined course relative to optical axis 12. The inclined course corresponds to a convex curvature. As seen from the perspective of the light beams travelling inside optical element 111, the curvature represents a concave reflection surface 116 for this light. The curved shape of lateral surface 116 is defined by curves of a section of a parabola 151. In particular, each lateral section of lateral surface 116 that is located in the same plane than optical axis 12 is defined by such a curve of a parabolic section. An axis of symmetry 152 of parabola 151 is tilted with respect to optical axis 12 such that axis of symmetry 152 of parabola 151 crosses optical axis 12 at an intersection point 153. A tilt angle 154 in between axis of symmetry 152 of parabola 151 and optical axis 12 is chosen such that the focal point of parabola 151 substantially coincides with virtual focal point 143 of the light reflected at inclined inner surface portion 127. In the embodiment shown in Fig. 6, tilt angle 142 corresponds to a value of about φ = 8°.

A circumference of lateral surface 116 is thus defined by the curves of a section of parabola 151 encircling optical axis 12 in a rotational symmetric manner. This results in a circular arrangement of the focal points of those curves of a parabolic section such that they are centered at optical axis 12 on an imaginary plane perpendicular to optical axis 12. The circle of focal points of those curves of a parabolic section substantially coincides with the circle of virtual focal points of the light reflected at inclined inner surface portion 127.

Inner optical element 111 is arranged inside cavity 25 of optical element 11 in such a way that they have optical axis 12 in common. Lateral surface 116 of inner optical element 111 extends along inner top surface portion 28 of optical element 11, wherein a bottom portion of inner optical element 111 including bottom surface 114 extends into bottom portion 31 of cavity 25 such that bottom surface 114 is closely positioned at light emitter 3. Inner top surface portion 28 of optical element 11 has been slightly altered as compared to the first embodiment shown in Figs.1 - 3. In the second embodiment shown in Figs. 4 - 6, inner top surface portion 28 comprises a slight indentation 104 along its conic surface in order to allow accommodation of curved lateral surface 116 of inner optical element 111. Lateral surface of inner optical element 111 and inner top surface portion 28 of optical element 11 are in mutual contact substantially in the direction of an opening angle 142 relative to optical axis 12 seen from the position of light emitter 3. In the embodiment shown in Fig. 6, opening angle 142 corresponds to a value of about β = 22°. The angle of contact between the two surfaces 28, 142 corresponds to an opening angle 142 because it determines an angular range with respect to optical axis 12 in which light emitted from light emitter 3 can pass through bottom surface 114 of inner optical element 111 without entering in contact with the surface of optical element 11. Outside this angular range, the emitted light enters optical element 11 at inclined bottom surface portion 36.

Optical emission device 101 further comprises a top cover 161. Top cover 161 is only illustrated in Fig. 6. Top cover 161 is arranged above top side 19 of optical element 11 and above top side 119 of inner optical element 111. Top cover 161 substantially corresponds to top cover 61 of the optical emission device 1 according to the first embodiment shown in Figs.1 - 3, with the exception that no lens 64 is provided. The role of lens 64 from device 1 according to the first embodiment is taken over by inner optical element 111 in device 101 according to the second embodiment.

An exemplary mode of operation of inner optical element 111 of optical emission device 101 based on a light path 171 shown in Fig. 6 is subsequently described. Light beam 171 is emitted from light emitter 3 at an angular range relative to optical axis 12 below opening angle 142. Therefore, light beam 171 can enter bottom surface 114 of inner optical element 111, from where light beam 171 is dispersed toward inclined inner surface portion 127. At inclined inner surface portion 127, a first total reflection takes place in which light beam 171 is redirected with respect to virtual focal point 143. The redirected path of light beam 171 leads to lateral surface 116. On lateral surface 116, a second total reflection of light beam 171 takes place. Due to the curved shape of lateral surface 116 defined by the curves of the parabolic section having a focal point at the position of virtual focal point 143 of inclined inner surface portion 127, the reflected light beams are collimated to a narrower beam. Reflected light beam 171 is then directed toward inclined top surface portion 123. At top surface portion 123 another dispersion of light beams 171 occurs resulting in a further narrowing in a parallel direction to optical axis 12. As a result, a more effective light collection as compared to a light collection with lens 42 according to the optical emission device 1 of the first embodiment can be achieved.

The above described experiments with a target set on a distance of 0.3 m from the device have also been conducted for optical emission device 101 according to the second embodiment. Measurements only using inner optical element 111 as a means for collimation of the emitted light have shown the results of an output power value of 0.18 W and a spot size having a FWHM of 10 mm. Measurements only employing optical element 11 as a means for collimation of the emitted light have resulted in an output power value of 0.59 W and a spot size with a FWHM of 15.5 mm. Measurements employing both optical element 11 and inner optical element 111 as a means for collimation of the emitted light, as depicted in Fig. 6, have shown that an output power value of 0.75 W and a spot size with a FWHM of 13 mm can be achieved. It follows from these experiments that at least when a small beam size of the outgoing light beam is an important parameter, optical emission device 101 according to the second embodiment has superior properties. Yet the resulting output power has been measured to be slightly lower as compared to optical emission device 1 according to the first embodiment.

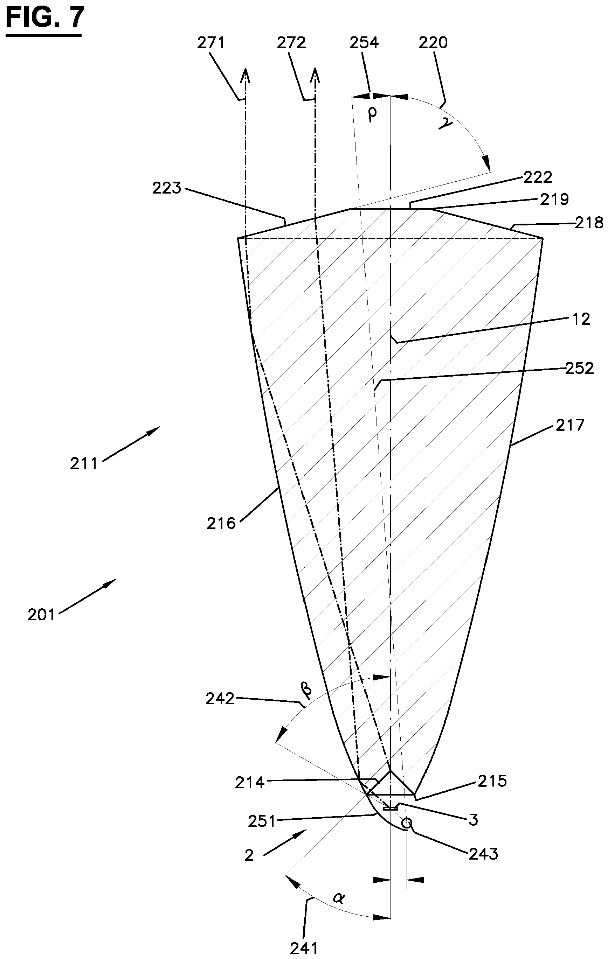

Fig. 7 depicts an optical emission device 201 according to a third embodiment. Optical emission device 201 comprises a mount 2 for a light emitter 3 and an optical element 211. Mount 2 for light emitter 3 is only schematically depicted by showing the relative position of light emitter 3. Corresponding features with respect to the first and second embodiment are designated by the same reference numerals.

Optical element 211 is formed from a material with a refractive index larger than 1.0 in a rotational-symmetric shape relative to optical axis 12. Optical element 211 comprises a bottom surface 214 at a bottom side 215, a lateral surface 216 at a lateral side 217, and a top surface 218 at a top side 219. Top side 219 is solid. Lateral surface 216 and top surface 218 form an outer surface of optical element 211. In inner surface of optical element is formed by bottom surface 214.

Fig. 7 shows a lateral section of optical emission device 201 in the plane of optical axis 12. In the configuration shown in Fig. 7, mount 2 is configured such that light emitter 3 is arranged below bottom surface 214. In particular, light emitter 3 is located outside the cavity delimited by bottom surface 214. Thus, only light emitted from light emitter 3 below a threshold emission angle 242 relative to optical axis 12 can enter optical element 211 through bottom surface 214. Mount 2 is configured such that light emitter 3 is arranged in a way that emission angle 242 is at least β = 60°.

Inner bottom surface 214 has an inclined course relative to an imaginary plane perpendicular to optical axis 12. Inclined bottom surface 214 forms a conic surface expanding toward bottom side 215 of optical element 211. The conic surface has a gradient angle 241 relative to optical axis 12. In the embodiment shown in Fig. 7, gradient angle 241 corresponds to a value of about α = 35°. This corresponds to an inclination angle of bottom surface 214 relative to an imaginary plane perpendicular to optical axis 12 of about 90°- α = 55°. The value of the inclination angle determines an angle at which the light emitted from light emitter 3 enters inclined bottom surface 214 and thus also the dispersion angle of the light inside optical element 211 after passage through this surface portion. Due to the dispersion of light at inclined bottom surface 214, virtual focal points 243 for the light entering bottom surface 214 are provided which are arranged on a circle centered at optical axis 12 on an imaginary plane perpendicular to optical axis 12, in an analogous manner as already described above.

Top surface 218 of optical element 211 comprises an inclined surface portion 223 and a flat surface portion 222. Flat top surface portion 222 is located at a center region of top side 219 and extends in parallel to an imaginary plane perpendicular to optical axis 12. Top surface portion 223 has an inclined course relative to an imaginary plane perpendicular to optical axis 12 in such a way that inclined top surface portion 223 rises at a linear gradient toward optical axis 12. In the embodiment shown in Fig. 7, a gradient angle 220 of inclined top surface portion 223 relative to optical axis 12 is about γ = 73°. This corresponds to an inclination angle of top surface portion 223 relative to an imaginary plane perpendicular to optical axis 12 of about 90°- γ = 17°. The inclination angle is chosen such that the dispersion of the light at inclined top surface portion 223 directs the light substantially in parallel to optical axis 12.

Lateral surface 216 extends from bottom side 215 to an outer end of inclined top surface portion 223 along optical axis 12 with a continuously increasing diameter of its cross section, such that lateral surface 216 has an inclined course relative to optical axis 12. The inclined course corresponds to a convex curvature of lateral surface 216, wherein the curved shape is defined by curves of a section of a parabola 251 in the above described manner. In the embodiment shown in Fig. 7, a tilt angle 254 of an axis of symmetry 252 of parabola 251 corresponds to a value of about φ = 5°. A circle of focal points of lateral surface 216 corresponding to a respective focal point of parabola 251 substantially coincides with the circle of virtual focal points of the light dispersed at bottom surface 216.

An exemplary mode of operation of optical emission device 201 is illustrated by a path of light beams 271, 272 shown in Fig. 7. An initial propagation direction of light beams 271, 272 leads to inclined bottom surface 214, where a dispersion of light beams 271, 272 takes place in which they are redirected relative to common virtual focal point 243. The redirected path of light beams 271, 272 leads to lateral surface 216, where they can be collected over a relatively large surface range and where they are then reflected in a collimated fashion to a narrower beam due to the specific geometric properties of lateral surface 216 in relation to the geometry of inclined bottom surface 214. Reflected light beams 271, 272 are then directed toward inclined top surface portion 223, where another dispersion in parallel to optical axis 12 occurs. The resulting outgoing light beam is effectively narrowed.

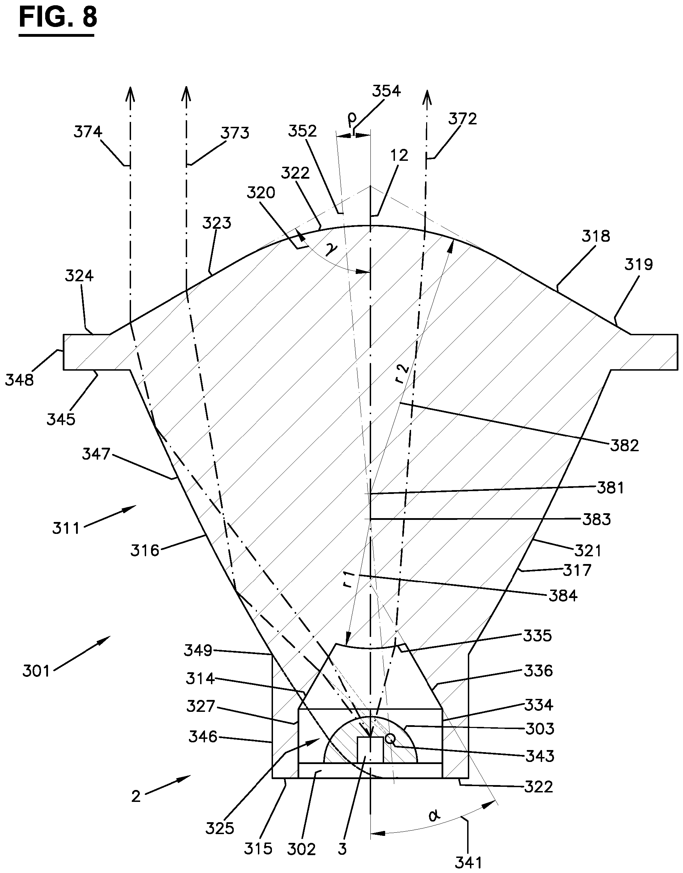

Fig. 8 shows a lateral section of an optical emission device 301 according to a fourth embodiment. Optical emission device 301 comprises a mount 2 for a light emitter 3 and an optical element 311. Corresponding features with respect to the first, second, and third embodiment described above are designated by the same reference numerals.

Mount 2 comprises a base plate 302 on which light emitter 3 is arranged in a central position with respect to optical axis 12. Light emitter 3 is surrounded by a lens 303 formed from a material having a refractive index larger than 1.0. Lens 303 has a hemispheric shape. Lens 303 is also disposed on top of base plate 302 such that it is rotationally-symmetrical centered around optical axis 12.

Optical element 311 is formed from a material with a refractive index larger than 1.0 in a rotational-symmetric shape relative to optical axis 12. Optical element 311 comprises a bottom surface 314 at a bottom side 315, a lateral surface 316 at a lateral side 317, and a top surface 318 at a top side 319. Top side 319 is solid. An external surface 321 of optical element 311 is constituted by lateral surface 316, an outer flat bottom portion 322 of bottom surface 314, and top surface 318.

Top surface 318 of optical element 311 comprises a flat outer top surface portion 324, an inclined middle top surface portion 323 and a curved central top surface portion 322. Outer surface portion 324 is substantially perpendicular with respect to optical axis 12. Middle surface portion 323 rises at a linear gradient toward optical axis 12 at a constant gradient angle 320 relative to optical axis 12. In the embodiment shown in Fig. 8, a gradient angle 320 of middle top surface portion 323 relative to optical axis 12 is about γ = 60°. This corresponds to an inclination angle of top surface portion 323 relative to an imaginary plane perpendicular to optical axis 12 of about 90°- γ = 30°. The value of the inclination angle determines an angle at which the light passing through optical element 311 exits top surface portion 323.

Central surface portion 322 defines a convex curvature of optical element 311. The curvature is defined by a constant radial distance 382 from a central point 381 located on optical axis 12. In this way a lens 322 is provided at top side 319 of optical element 311. As seen from the light passing the inner volume of optical element 311, the curvature of central surface portion 322 is thus concave with respect to the surroundings of optical element 311. At the intersection point of central surface portion 322 with optical axis 12, central surface portion 322 is perpendicular with respect to optical axis 12.

Lateral surface 316 of optical element 311 comprises an upper lateral cylindrical portion 348, a middle lateral expanding portion 347, and a lower lateral cylindrical portion 346. Upper lateral cylindrical portion 348 joins flat outer top surface portion 324 at its upper edge and defines a maximum diameter of optical element 311 with respect to optical axis 12. Upper lateral cylindrical portion 348 is connected at its lower edge to the upper edge of middle lateral expanding portion 347 via a flat connecting portion 345. Flat connecting portion 345 extends in parallel to flat outer top surface portion 324. Thus, flat connecting portion 345 and flat outer top surface portion 324 define an outer plate-shaped portion of optical element 311 that can be used for its mounting.

A circumference of middle lateral expanding portion 347 is defined by the curves of a section of parabola encircling optical axis 12 in a rotational symmetric manner. An axis of symmetry 352 of the parabola is tilted with respect to optical axis 12 such that axis of symmetry 352 of the parabola crosses optical axis 12 at an intersection point 343. Thus, a focal point 343 of the parabola is located on axis 352 at the intersection point, axis 352 forming an angle ρ with the optical axis 12. Lower lateral surface portion 346 and middle lateral surface portion 47 are joined at an outer connecting edge 349. Lower lateral surface portion 346 is cylindrical and surrounds a lower cavity 325 of optical element 311.

Bottom surface 314 of optical element 311 is provided by outer flat bottom portion 322 and an inner bottom surface portion 327 comprising a lower inner cylindrical sidewall 334, a middle inner inclined surface portion 336, and an upper inner curved portion 335. Optical axis 12 is directed in parallel to lower inner cylindrical sidewall 334. The maximum diameter of lower cavity 325 is defined by the diameter of lower inner cylindrical sidewall 334. The diameter corresponds to the diameter of base plate 302. Light emitter 3 and surrounding lens 303 are arranged inside the volume portion of lower cavity 325 that is delimited by lower inner cylindrical sidewall 334 defining an insertion space.

Middle inner inclined surface portion 336 adjoins lower inner cylindrical sidewall 334 at its lower edge. Inclined surface portion 336 has an inclined course relative to an imaginary plane perpendicular to optical axis 12. Thus, inclined bottom surface portion 336 forms a conic surface expanding toward bottom side 315 of optical element 11. At its opposed upper end, inclined bottom surface portion 336 adjoins upper inner curved portion 335. Inner curved portion 335 delimits an upper end of lower cavity 325. Inner curved portion 335 exhibits a convex curvature. The curvature is defined by a constant radial distance 384 from a central point 383 located on optical axis 12. The radius 384 of the curvature of inner curved portion 335 is smaller than the radius 382 of the curvature of central top surface portion 322.

The conic surface of inclined bottom surface portion 336 has a gradient angle 341 relative to optical axis 12. In the embodiment shown in Fig. 8, gradient angle 341 corresponds to a value of about α = 30°. This corresponds to an inclination angle of bottom surface portion 336 relative to an imaginary plane perpendicular to optical axis 12 of about 90°- α = 60°. The value of the inclination angle determines an angle at which the light emitted from light emitter 3 and diffracted at the surface of hemispherical lens 303 enters inclined bottom surface portion 336 and thus also the dispersion angle of the light inside optical element 311 after passage through this surface portion. Due to the dispersion of light at the surface of hemispherical lens 303 and the subsequent dispersion of the light at inclined bottom surface portion 336, a virtual focal point for the light entering bottom surface portion is provided. It corresponds with focal point 343 of the respective curve of a section of parabola defining middle lateral expanding portion 347.

Subsequently, an exemplary mode of operation of optical emission device 311 based on a respective path of three light beams 372, 373, 374, as illustrated in Fig. 8, is described. Light beam 372 is emitted from light emitter 3 at an angular range relative to optical axis 12 below an opening angle at which the emitted light is diffracted at the surface of hemispherical lens 303 toward inclined bottom surface portion 336. Therefore, light beam 372 is directed toward upper inner curved portion 335. Diffraction at this concave surface 335 leads to a narrowing of light beam 372 toward optical axis 12. Light beam 372 nevertheless propagates at a path slightly diverging from optical axis 12. Next, light beam 372 hits the curved surface of central top surface portion 322. Central top surface portion 322 causes a collimation of light beam 372 in parallel to optical axis 12. As a result, the outgoing light beam 372 can be effectively narrowed.

Light beams 373, 374 are emitted from light emitter 3 at an angular range relative to optical axis 12 above the opening angle starting from which the emitted light is diffracted at the surface of hemispherical lens 303 toward inclined bottom surface portion 336. Therefore, the initial propagation direction of light beams 373, 374 leads to inclined bottom surface portion 336 of optical element 311. Upon entering optical element 311 through inclined bottom surface portion 336, a dispersion of light beams 373, 374 takes place, wherein light beams 373, 374 are redirected with respect to their virtual focal point 343. The redirected path of light beams 373, 374 leads to inclined lateral surface portion 347. On inclined lateral surface portion 347, a total reflection of light beams 373, 374 takes place. Due to the curved shape of inclined lateral surface portion 347 defined by the parabolic curves having a focal point at the position of the virtual focal point of inclined bottom surface portion 336, light beams 373, 374 collected over this comparatively large surface region 347 are collimated to a narrower entire beam after their total reflection. Reflected light beams 373, 374 are then directed toward inclined middle top surface portion 323. At inclined middle top surface portion 323 another dispersion of light beams 373, 374 occurs resulting in a further narrowing of light beams 373, 374 in a parallel direction to optical axis 12. As a result, an effective light collection over a large emission range, which has been selectively chosen to lie outside the opening angle, can be achieved by optical element 311 and an effective collimation of this collected light to a narrow outgoing light beam.

From the foregoing description, numerous modifications of the optical emission device according to the invention are apparent to one skilled in the art without leaving the scope of protection of the invention that is solely defined by the claims.

## Claims

1. An optical emission device comprising
- an optical element (11, 111, 211, 311) formed from a material with a refractive index larger than 1.0 in a shape comprising at least a lateral surface portion (16, 116, 216, 316) a top surface portion (18, 118, 218, 318), and a bottom surface portion (14, 114, 214, 314) that are rotationally-symmetric to an optical axis (12); and
- a mount (2) for a light emitter (3) on the optical axis (12) below the bottom surface portion of the optical element (11, 111, 211, 311) such that at least a part of the light emitted from the light emitter (3) can enter the optical element (11, 111, 211, 311) through the bottom surface portion and be reflected on the lateral surface portion before leaving the optical element (11, 111, 211, 311) through the top surface portion,
**characterized in that** the lateral surface portion (16,, 116, 216, 316) has an inclined course (47, 116, 216, 347) relative to the optical axis (12), said inclined course of the lateral surface portion being chosen such that the light (73, 74, 171, 271, 272, 373, 374) reflected at the lateral surface portion is not directed in parallel to the optical axis (12),
and that the top surface portion (18, 118, 218, 318) has an inclined course (23, 28, 123, 223, 323) relative to an imaginary plane perpendicular to the optical axis (12), said inclined course of the top surface portion being chosen such that the light (73, 74, 171, 271, 272, 373, 374) leaving the optical element (11, 111, 211, 311) through the top surface portion is substantially directed in parallel to the optical axis (12).

2. The optical emission device according to claim 1, **characterized in that** said inclined course of the lateral surface portion comprises a curvature of the lateral surface portion (16, 116, 216, 316).

3. The optical emission device according to claim 2, **characterized in that** said curvature of the lateral surface portion (16, 116, 216, 316) is defined by curves of a conic section (51, 151, 251, 347).

4. The optical emission device according to claim 3, **characterized in that** a focal point (43,143, 243, 343) of said conic section for each of said curves is spaced apart from the optical axis (12).

5. The optical emission device according to one of claims 1 to 4, **characterized in that** said inclined course of the top surface portion (18, 118, 218, 318) is provided by a substantially linear gradient (23, 28, 123, 223, 323) of the top surface portion towards the optical axis (12) relative to said imaginary plane perpendicular to the optical axis (12).

6. The optical emission device according to one of claims 1 to 5, **characterized in that** the bottom surface portion (14, 114, 214, 314) comprises an inner surface portion (27, 34, 35, 36, 114, 214, 334, 335, 336) of the optical element (11, 111, 211, 311) provided inside a cavity (25, 31, 32, 125, 325) at a bottom side (15, 115, 215, 315) of the optical element (11, 111, 211, 311).

7. The optical emission device according to one of claim 6, **characterized in that** the mount (2) for the light emitter (3) is configured such that the light emitter (3) is placed inside said cavity (25, 31, 32, 125, 325) at the bottom side (15, 115, 215, 315) of the optical element (11, 111, 211, 311).

8. The optical emission device according to one of claims 1 to 6, **characterized in that** the bottom surface portion (14, 114, 214, 314) comprises an inclined course (36, 214, 314) relative to an imaginary plane perpendicular to the optical axis (12), said inclined course of the bottom surface portion being chosen such that at least part of the light (73, 74, 171, 271, 272, 373, 374) entering the optical element (11, 111, 211, 311) through the bottom surface portion is redirected in a different direction at the bottom surface portion.

9. The optical emission device according to claim 8, **characterized in that** said inclined course of the bottom surface portion (14, 114, 214, 314) is provided by a substantially linear gradient (36, 214, 336) of the bottom surface portion towards the optical axis (12) relative to said imaginary plane perpendicular to the optical axis (12).

10. The optical emission device according to one of claims 1 to 9, **characterized in that** the optical element (11, 111, 211, 311) comprises a cavity (25, 31, 32, 125, 325) extending through a total length of the optical element from the bottom surface portion (14, 114, 214, 314) to the top surface portion (18, 118, 218, 318) such that part of the light emitted from the light emitter (3) can travel through said cavity (25, 31, 32, 125, 325).

11. The optical emission device according to claim 10, **characterized in that** a lens (64, 322) is provided at a top side (19, 119, 219, 319) of the optical element (11, 111, 211, 311), the lens (64, 322) being configured such that the light traveling through said cavity (25, 31, 32, 125, 325) of the optical element is directed in parallel to the optical axis (12).

12. The optical emission device according to one of claims 1 to 11, **characterized in that** a front cover (61, 161) is provided on top of the top surface portion (18, 118, 218, 318), the front cover (61, 161) being transparent to at least part of the light leaving the optical element (11, 111, 211, 311) through the top surface portion.

13. The optical emission device according to claims 11 and 12, **characterized in that** the lens (64, 322) is provided on the front cover (61, 161) such that the lens (64) is substantially covering said cavity (25, 31, 32, 125, 325) at the top side (19, 119, 219, 319) of the optical element (11, 111, 211, 311).

14. The optical emission device according to one of claims 10 to 13, **characterized in that** an inner optical element (111) is provided inside said cavity (25, 31, 32, 125, 325), the inner optical element (111) being formed from a material with a refractive index larger than 1.0 in a shape comprising at least a lateral surface portion (16, 116, 216, 316), a top surface portion (18, 118, 218, 318), and a bottom surface portion (14, 114, 214, 314) that are rotationally-symmetric to the optical axis (12).

15. The optical emission device according to claims 14, **characterized in that** the bottom surface portion (14, 114, 214, 314) of the inner optical element (111) comprises a substantially flat course (114) parallel to an imaginary plane perpendicular to the optical axis (12).
